**Europäisches Patentamt**

**European Patent Office**

**Office européen des brevets**

(19)

(11) Numéro de publication : **0 524 086 A1**

# (12) DEMANDE DE BREVET EUROPEEN

(21) Numéro de dépôt : **92402036.5**

(22) Date de dépôt : **15.07.92**

(51) Int. Cl.⁵ : **G01R 27/02, G01K 7/24**

(30) Priorité : **18.07.91 FR 9109077**

(43) Date de publication de la demande :
**20.01.93 Bulletin 93/03**

(84) Etats contractants désignés :
**AT BE CH DE DK ES FR GB GR IT LI LU MC NL PT SE**

(71) Demandeur : **SOCIETE D'APPLICATIONS GENERALES D'ELECTRICITE ET DE MECANIQUE SAGEM**
**6, Avenue d'Iéna**
**F-75783 Paris Cédex 16 (FR)**

(72) Inventeur : **Levesque, Xavier**
**9 Grand Place**
**F-95000 Cergy (FR)**

(74) Mandataire : **Bloch, Gérard**
**2, square de l'Avenue du Bois**
**F-75116 Paris (FR)**

(54) **Méthode de mesure d'une résistance par évaluation de temps de charge d'un condensateur.**

(57)    Successivement, par un générateur d'impédance variable (3), on charge une première fois un condensateur (1) à travers une première résistance de référence (5), pendant un temps qu'on mesure,
on laisse le condensateur (1) se décharger,
on charge une deuxième fois le condensateur (1), à travers la résistance à mesurer (6) pendant un temps qu'on mesure, et,
pour s'affranchir de l'impédance interne du générateur, on charge une troisième fois le condensateur (1) à travers une deuxième résistance de référence (7) pendant un temps qu'on mesure.
On tire la valeur de la résistance à mesurer (6) des trois temps de charge, le condensateur (1) n'étant chargé qu'une seule fois à travers la résistance à mesurer (6).
L'invention s'applique bien à la détermination à bord d'un véhicule, de la température extérieure.

FIG 3

EP 0 524 086 A1

La présente invention concerne une méthode de mesure d'une résistance par évaluation de temps de charge d'un condensateur. Une telle méthode peut être appliquée, par exemple, à la détermination par thermistance, à bord d'un véhicule automobile, de la température extérieure.

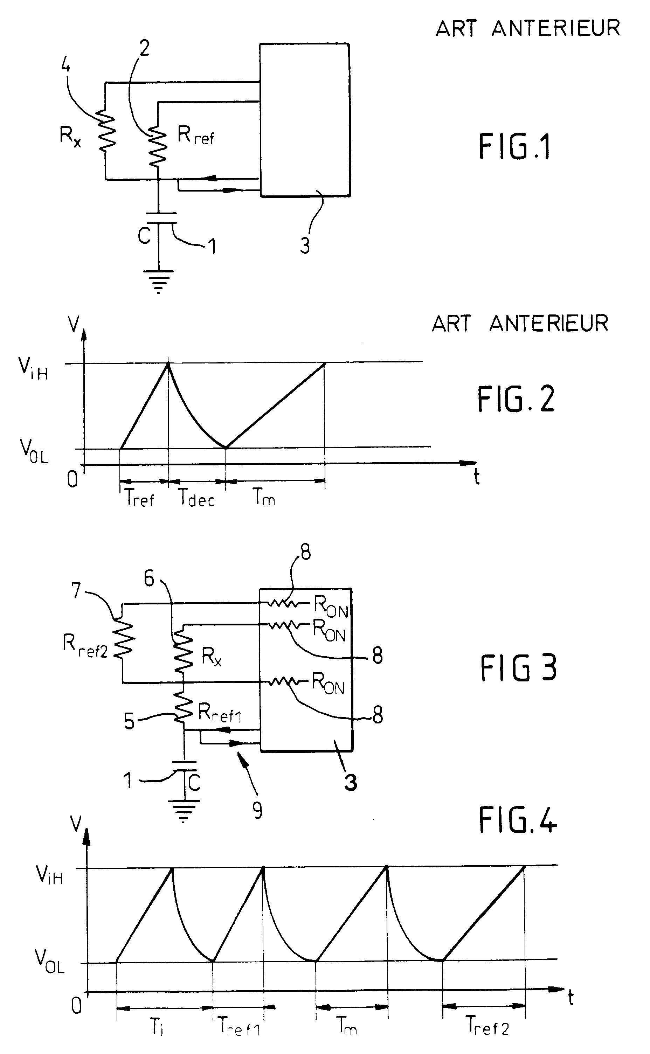

Actuellement, et en référence aux figures 1 et 2, la méthode de mesure se déroule de la manière suivante.

On commence par charger un condensateur C1, à travers une résistance de référence Rref 2 en série, à partir d'un générateur de tension 3. Quand, au bout d'un temps $T_{ref}$, la tension aux bornes du condensateur 1 a atteint une valeur prédéterminée $V_{iH}$, on laisse pendant un temps Tdec, le condensateur se décharger jusqu'à ce que sa tension redevienne égale à sa tension de départ $V_{oL}$. Puis on le recharge, non plus à travers la résistance 2, mais à travers la résistance Rx à mesurer 4, pendant un temps Tm jusquà ce que la tension à ses bornes redevienne égale à $V_{iH}$.

Des mesures des temps de charge Tref et Tm on déduit la valeur de Rx :

$$Tref = k\ Rref\ C$$
$$Tm = k\ Rx\ C$$

k étant une constance dépendant des valeurs de $V_{iH}$ et $V_{oL}$

$$\frac{Rx}{Rref} = \frac{Tm}{Tref}$$

$$Rx = \frac{Tm}{Tref}\ Rref$$

Une telle méthode serait satisfaisante si la valeur de la résistance Rx à mesurer ainsi que celle de la résistance Rref étaient très grandes par rapport à l'impédance interne du générateur de mesure. Ce n'est pas toujours le cas, car cette impédance interne peut varier. Alors, la mesure de Rx serait entachée d'erreur.

La présente invention vise donc à ne pas négliger l'impédance interne du générateur de tension de mesure tout en s'en affranchissant.

Le document FR-A-2 644 589 enseigne une méthode de mesure de la valeur d'une résistance, dans laquelle, et successivement, par un générateur d'impédance variable, on charge une première fois un condensateur à travers une première résistance de référence pendant un temps qu'on mesure, on laisse le condensateur se décharger, on charge une deuxième fois le condensateur à travers la résistance à mesurer pendant un temps qu'on mesure, on charge une troisième fois le condensateur à travers une deuxième résistance de référence pendant un temps qu'on mesure et on tire la valeur de la résistance à mesurer des trois temps de charge, le condensateur n'étant chargé qu'une seule fois à travers la résistance à mesurer.

Mais ce procédé de l'art antérieur ne visait absolument pas à s'affranchir de l'impédance interne du générateur, la charge du condensateur à travers les diverses résistances s'effectuant de surcroît respectivement par différents ports de sortie du générateur.

C'est donc dans ces conditions que la demanderesse propose son invention qui concerne un procédé du type défini juste ci-dessus, caractérisé par le fait que, pour s'affranchir de l'impédance interne du générateur, la première charge s'effectue à travers la première résistance de référence et l'impédance interne du générateur,

la deuxième charge, à travers la première résistance de référence, l'impédance interne du générateur et la résistance à mesurer et

la troisième charge, à travers la première et la deuxième résistances de référence et l'impédance interne du générateur.

Si dans la méthode du premier art antérieur cité ci-dessus, on s'affranchissait de la constante k par les mesures des deux temps de charge, une des deux charges étant effectuée à travers la résistance à mesurer, dans la méthode de l'invention, on s'affranchit non seulement de cette constante mais également de l'impédance interne du générateur. On remarquera encore que c'est parce qu'on dispose de trois temps de charge dont un seul dépend de la valeur de la résistance à mesurer qu'on s'affranchit de l'impédance interne du générateur tout en pouvant calculer la valeur de la résistance à mesurer.

Le document DE-A-3 101 994 enseigne aussi un procédé de mesure d'une résistance, à l'aide d'un circuit résistif de mesure comprenant, outre la résistance à mesurer, deux résistances en série, entre la masse et un générateur, et dont le point commun est relié à l'une des bornes de la résistance à mesurer dont l'autre borne peut être reliée au générateur. Il n'est toutefois pas question, dans ce dernier document, d'un quelconque problème d'impédance interne de générateur.

Malgré ce document DE-A-3 101 994, l'invention de la présente demande implique bien l'activité inventive requise. Au-delà du mérite d'avoir posé le problème de s'affranchir de l'impédance interne, il n'y avait aucune raison de penser qu'en substituant le circuit résistif du document DE-A-3 101 994 à celui du document FR-A-2 644 589, on pouvait s'affranchir de l'impédance interne du générateur du document FR-A-2 644 589, d'autant plus que, dans ce document, il est question de trois ports de sortie, et non de trois sorties d'un même port qui, seules, permettent d'avoir, en série avec chaque résistance, la même impédance interne du générateur.

EP 0 524 086 A1

Avantageusement, on charge le condensateur la première fois après une initialisation, consistant à le soumettre à un cycle de charge et décharge préalable.

Dans ce cas, chaque charge du condensateur s'effectue entre une tension d'initialisation et une tension de seuil prédéterminée, dont la valeur n'a d'ailleurs pas d'importance.

L'invention sera mieux comprise à l'aide de la description suivante, en référence au dessin annexé sur lequel :

- la figure 1 est une représentation schématique du système pour la mise en oeuvre de la méthode de mesure de l'art antérieur ;
- la figure 2 est un diagramme temporel des charges et décharges du condensateur du système de mesure de la figure 1 ;
- la figure 3 est une représentation schématique du système pour la mise en oeuvre préférée de la méthode de mesure de l'invention et
- la figure 4 est un diagramme temporel des charges et décharges du condensateur du système de mesure de la figure 3.

En référence à la figure 3, il va être décrit un dispositif de mesure d'une résistance Rx 6, à l'aide d'un générateur d'impédance variable 3, d'un condensateur 1, de capacité connue, de deux résistances de référence Rréf$_1$ 5 et Rréf$_2$ 7, de valeurs connues et d'un appareil de mesure, bien connu de l'homme de métier, de temps de charge et décharge du condensateur 1.

Le générateur 3 peut être un microprocesseur ou un microcontrôleur, qui est un microprocesseur associé à des temporisateurs et à des convertisseurs analogique - numérique et à entrée - sortie de commande. La mesure s'effectue de préférence en numérique en raison de la nécessité de mesurer et de calculer des temps et d'effectuer des opérations, comme cela sera abordé ci-après.

Les trois résistances 5, 6, 7 sont, par l'une de leurs bornes, reliées à trois sorties d'un même port de sortie du générateur 3. En série avec chacune de ces trois résistances se trouve donc la même impédance interne R$_{ON}$ 8 du générateur 3. Les autres bornes des résistances 6 et 7 sont reliées à la borne de la résistance 5 reliée au générateur 3, l'autre borne de la résistance 5 étant reliée à l'une des bornes du condensateur 1 dont l'autre borne est reliée à la masse. Le point de liaison entre la résistance 5 et le condensateur 1 est relié au générateur 3 par une double liaison 9 pour, d'une part, la charge et, d'autre part, la décharge d'initialisation du condensateur 1.

En référence à la figure 4, on commence par initialiser le dispositif, pendant un temps Ti, en chargeant le condensateur depuis une tension d'initialisation donnée VoL jusqu'à une tension de seuil ViH donnée, puis en le déchargeant à VoL.

Après le cycle d'initialisation Ti, on soumet le condensateur 1 à trois autres cycles de charge et décharge, entre les tensions VoL et ViH :

- une première fois à travers les résistances Rref$_1$ et R$_{ON}$, avec un temps de charge Tref$_1$ qu'on mesure,
- une deuxième fois à travers les résistances Rref$_1$, Rx et R$_{ON}$ en série, avec un temps de charge Tm qu'on mesure et
- une troisième fois à travers les résistances Rref$_1$, Rref$_2$ et R$_{ON}$ en série, avec un temps de charge Tref$_2$ qu'on mesure.

On remarquera que les portions de courbe de la figure 4 relative aux temps de charge du condensateur sont quasiment rectilignes pour correspondre à la partie de l'exponentielle de charge. Le calcul de la valeur de Rx peut alors être effectué, en symbolisant Rref$_1$, Rref$_2$, Tref$_1$ et Tref$_2$ respectivement par R$_1$,R$_2$, T$_1$ et T$_2$.

$$T_1 = kC(R1 + R_{ON}) \quad (1)$$
$$T_m = kC(R_1 + Rx + R_{ON}) \quad (2)$$
$$T_2 = kC(R_1 + R_2 + R_{ON}) \quad (3)$$

Des relations (1) et (3), on tire

$$\frac{T_1}{T_2} = \frac{R1 + R_{ON}}{R_1 + R_2 + R_{ON}}$$

3

$$T_1R_1 + T_1R_2 + T_1R_{ON} = T_2R_1 + T_2R_{ON}$$

$$R_{ON}(T_1 - T_2) = T_2R_1 - T_1R_1 - T_1R_2$$

$$= R_1(T_2 - T_1) - R_2T_1$$

$$R_{ON} = R_2 \frac{T_1}{T_2 - T_1} - R_1 \qquad (4)$$

Des relations (1) et (2), on tire

$$\frac{T_1}{Tm} = \frac{R_1 + R_{ON}}{R_1 + Rx + R_{ON}}$$

$$T_1R_1 + T_1Rx + T_1R_{ON} = Tm\,R_1 + TmR_{ON}$$

$$T_1Rx = Tm\,R_1 + (Tm - T_1)R_{ON} - T_1R_1$$

$$Rx = \frac{Tm - T_1}{T_1} R1 + \frac{Tm - T_1}{T_1} R_{ON}$$

$$= \frac{Tm - T_1}{T_1} (R1 + R_{ON}) \qquad (5)$$

En reportant dans la relation (5) la valeur de $R_{ON}$ donnée par la relation (4), on obtient :

$$Rx = \frac{Tm - T_1}{T_1} R_2 \frac{T_1}{T_2 - T_1}$$

$$Rx = R_2 \frac{Tm - T_1}{T_2 - T_1}$$

En ayant soumis le condensateur à un troisième cycle de charge - décharge, on a donc rendu la mesure plus précise par intégration de l'impédance interne du générateur, en particulier la résistance des transistors de commande dans le cas d'une génération de tension par microprocesseur ou microcontrôleur.

**Revendications**

1. Méthode de mesure de la valeur d'une résistance (6) dans laquelle, et successivement, par un générateur d'impédance variable (3), on charge une première fois un condensateur (1) à travers une première résistance de référence (5) pendant un temps qu'on mesure,
on laisse le condensateur (1) se décharger,
on charge une deuxième fois le condensateur (1) à travers la résistance à mesurer (6) pendant un temps qu'on mesure, on charge une troisième fois le condensateur (1) à travers une deuxième résistance de référence (7) pendant un temps qu'on mesure et on tire la valeur de la résistance à mesurer (6) des trois temps de charge, le condensateur (1) n'étant chargé qu'une seule fois à travers la résistance à mesurer (6), caractérisé par le fait que, pour s'affranchir de l'impédance interne du générateur, la première charge s'effectue à travers la première résistance de référence (5) et l'impédance interne (8) du générateur (3), la deuxième charge, à travers la première résistance de référence (5), l'impédance interne (8) du générateur et la résistance à mesurer (6) et
la troisième charge, à travers la première (5) et la deuxième (7) résistances de référence et l'impédance interne (8) du générateur.

2.  Méthode selon la revendication 1, dans laquelle on charge le condensateur (1) la première fois après une initialisation.

3.  Méthode selon la revendication 2, dans laquelle chaque charge du condensateur (1) s'effectue entre une tension d'initialisation et une tension de seuil prédéterminée.

4.  Méthode selon l'une des revendications 1 à 3 qui est une méthode de mesure numérique.

ART ANTERIEUR

FIG.1

ART ANTERIEUR

FIG.2

FIG 3

FIG.4

Office européen
des brevets

**RAPPORT DE RECHERCHE EUROPEENNE**

Numero de la demande

EP    92 40 2036

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y,D | DE-A-3 101 994 (LGZ LANDIS&GYR)<br>* abrégé; revendications 1-6; figure 1 *<br>* page 6, ligne 9 - ligne 15 *<br>* page 8, ligne 27 - ligne 35 *<br>--- | 1-4 | G01R27/02<br>G01K7/24 |
| Y,D | FR-A-2 644 589 (DELTA-DORE)<br>* abrégé; figure *<br>--- | 1-4 | |
| A | US-A-4 987 372 (J.OFORI-TENKORANG)<br>* abrégé; figures 1-3 *<br>* colonne 5, ligne 17 - ligne 23 *<br>* colonne 6, ligne 5 - ligne 13 *<br>--- | 1 | |
| A | US-A-4 841 458 (M.R.LEVINE ET AL.)<br>* abrégé; figures 1-4 *<br>* colonne 2, ligne 5 - colonne 3, ligne 13 *<br>--- | 1 | |
| A | DE-A-3 634 052 (PHILIPS)<br>* abrégé; figure 2 *<br>* colonne 5, ligne 62 - ligne 64 *<br><br>----- | 1 | |

**DOMAINES TECHNIQUES RECHERCHES (Int. Cl.5)**

G01R
G01K

Le présent rapport a été établi pour toutes les revendications

| Lieu de la recherche | Date d'achèvement de la recherche | Examinateur |
|---|---|---|
| BERLIN | 20 OCTOBRE 1992 | S.C.Fritz |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)